# EUROPEAN PATENT APPLICATION

(11) **EP 3 257 914 A1**
(43) Date of publication of application: **20.12.2017**
(21) Application number: 16748899.8
(22) Date of filing: 03.02.2016
(51) Int. Cl.: C09K 11/61, C09K 11/00, G02B 5/20, H01L 31/055

(54) **FLUORESCENT BODY, WAVELENGTH CONVERSION MEMBER, AND PHOTOVOLTAIC DEVICE**

(30) Priority: 09.02.2015 JP 2015022868; 28.10.2015 JP 2015211665
(71) Applicant: Panasonic Intellectual Property Management Co., Ltd., Osaka-shi, Osaka 540-6207 (JP)
(72) Inventor: SATO, Natsuki, Osaka-shi Osaka 540-6207 (JP); IKOMA, Yoshimitsu, Osaka-shi Osaka 540-6207 (JP); OSHIO, Shozo, Osaka-shi Osaka 540-6207 (JP)
(74) Representative: Müller-Boré & Partner Patentanwälte PartG mbB
(86) International application number: PCT/JP2016/000557
(87) International publication number: WO 2016/129252

(57) **Abstract**

A phosphor of the present invention has a crystal structure in which at least one of Ce³⁺ and Eu²⁺ is substituted for a part of a host crystal that contains at least one of an alkaline earth metal element and a rare earth element and does not contain an alkaline metal element. In the phosphor, a light emission spectrum measured at room temperature has a light emission peak, which is derived from at least one of Ce³⁺ and Eu²⁺, within a wavelength range of 440 nm or more to less than 1200 nm, the light emission peak indicates a maximum intensity value of the light emission spectrum, and a refractive index is 1.41 or more to less than 1.57.

## Description

### TECHNICAL FIELD

The present invention relates to a phosphor, which is capable of converting ultraviolet light into visible light or infrared light at room temperature or more, has a small refractive index difference from that of a sealing material of a wavelength conversion member, has light emission characteristics unchanged even if coming into contact with moisture, and has high reliability. Moreover, the present invention relates to a wavelength conversion member and a photovoltaic device, which include this phosphor.

### BACKGROUND ART

In general, in a solar cellwvs, photoelectric conversion efficiency of ultraviolet light is lower than photoelectric conversion efficiency of visible light. For example, in a general solar cell, in the ultraviolet light in which a wavelength ranges from 300 nm or more to less than 400 nm, the photoelectric conversion efficiency is low, and in the region of the visible light and the infrared light, in which a wavelength ranges from 400 nm or more to less than 1200 nm, the photoelectric conversion efficiency is high. Moreover, such ultraviolet light in which a wavelength stays within a range less than 380 nm is prone to damage the solar cell. Therefore, in the conventional solar cell, the ultraviolet light in which the wavelength stays within the range less than 380 nm has been cut by means of a filter.

However, if the ultraviolet light in which the wavelength stays within the range less than 380 nm can be used for power generation, then the photoelectric conversion efficiency of the solar cell is expected to be improved. Therefore, in recent years, in the solar cell, it has been studied not just to cut the ultraviolet light in which the wavelength stays within the range less than 380 nm, but to convert the ultraviolet light concerned into long-wavelength light and to use the long-wavelength light for power generation.

For example, there has been studied a technology for providing a wavelength conversion layer, which converts the ultraviolet light into the visible light or the infrared light, on a surface of the solar cell. As the wavelength conversion layer, for example, a sheet in which a phosphor is dispersed in a sealing material made of a transparent resin has been studied.

It is preferable that the wavelength conversion layer exhibit high transmittance for the visible light and the infrared light in a wavelength region where the photoelectric conversion efficiency of the solar cell is high. This is because, if the transmittance of the wavelength conversion layer for the visible light and the infrared light is low, then it is apprehended that a degree of decrease of the photoelectric conversion efficiency, which follows a decrease of the transmittance, may exceed enhancement of the photoelectric conversion efficiency due to provision of the wavelength conversion layer. It is presumed that the wavelength conversion layer having high transmittance for the visible light and the infrared light can be obtained by reducing the refractive index difference between the phosphor and the sealing material in which the phosphor is dispersed.

Heretofore, as such a phosphor having a small refractive index difference from that of the sealing material, a barium fluoride phosphor activated by Eu²⁺ has been described in Patent Literature 1.

### CITATION LIST

### PATENT LITERATURE

Patent Literature 1: English translation of Japanese Unexamined Patent Application Publication No. H02 (1990)-503717

### SUMMARY OF INVENTION

### TECHNICAL PROBLEM

However, there was a problem that the barium fluoride phosphor hardly emitted light at 25°C or higher, that is, was poor in temperature quenching characteristics. As described above, heretofore, a phosphor has not been known, which is suitable for the solar cell, is capable of converting the ultraviolet light into the visible light or the infrared light with high efficiency at room temperature or more, and has a refractive index close to that of a general sealing material. Moreover, since the phosphor for the solar cell is often used outdoors, it is preferable that the light emission characteristics not be changed even if the phosphor comes into contact with moisture.

The present invention has been made in consideration of the above-described problems. It is an object of the present invention to provide a phosphor, which is capable of converting the ultraviolet light into the visible light or the infrared light with high efficiency at room temperature or more, has a small refractive index difference from that of the sealing material of the wavelength conversion member, has the light emission characteristics unchanged even if coming into contact with moisture, and has high reliability. It is another object of the present invention to provide a wavelength conversion member and a photovoltaic device, which include this phosphor.

### SOLUTION TO PROBLEM

In order to solve the above-described problems, a phosphor according to a first aspect of the present invention has a crystal structure, in which at least one of Ce³⁺ and Eu²⁺ is substituted for a part of a host crystal that contains at least one of an alkaline earth metal element and a rare earth element and does not contain the alkaline metal element. In the phosphor according to the aspect of the present invention, a light emission spectrum measured at room temperature has a light emission peak derived from at least one of Ce³⁺ and Eu²⁺ within a wavelength range of 440 nm or more to less than 1200 nm, and this light emission peak exhibits a maximum intensity value of the above-described light emission spectrum. Moreover, a refractive index of the phosphor according to the aspect of the present invention is 1.41 or more to less than 1.57.

A wavelength conversion member according to a second embodiment of the present invention includes the above-described phosphor.

A photovoltaic device according to a third embodiment of the present invention includes the above-described phosphor.

### BRIEF DESCRIPTION OF DRAWINGS

FIG. 1 is a cross-sectional view schematically showing a solar cell module according to a first embodiment.
FIG. 2 is a cross-sectional view schematically showing a solar cell module according to a second embodiment.
FIGS. 3A and 3B are views showing scattering intensity distributions of a scattering material when the scattering intensity distributions are simulated by setting a particle size of the scattering material included in the wavelength conversion member of FIG. 1 to 100 nm, and showing scattering intensity distributions of the scattering material when a straight direction component of the scattering intensity is normalized to 1.
FIGS. 4A and 4B are views showing scattering intensity distributions of the scattering material when the scattering intensity distributions are simulated by setting the particle size of the scattering material included in the wavelength conversion member of FIG. 1 to 300 nm, and showing scattering intensity distributions of the scattering material when the straight direction component of the scattering intensity is normalized to 1.
FIGS. 5A and 5B are views showing scattering intensity distributions of the scattering material when the scattering intensity distributions are simulated by setting the particle size of the scattering material included in the wavelength conversion member of FIG. 1 to 500 nm, and showing scattering intensity distributions of the scattering material when the straight direction component of the scattering intensity is normalized to 1.
FIGS. 6A and 6B are views showing scattering intensity distributions of the scattering material when the scattering intensity distributions are simulated by setting the particle size of the scattering material included in the wavelength conversion member of FIG. 1 to 1000 nm, and showing scattering intensity distributions of the scattering material when the straight direction component of the scattering intensity is normalized to 1.
FIG. 7 is a graph showing wavelength dependences of transmittances of scattering members in which the scattering material is dispersed.
FIG. 8 is a graph showing excitation characteristics and light emission characteristics of a compound of Example 2.

### DESCRIPTION OF EMBODIMENTS

A description will be made below of a photovoltaic device according to this embodiment, a wavelength conversion member that constitutes the photovoltaic device, and a phosphor included in the wavelength conversion member with reference to the drawings.

### [Photovoltaic device]

### [First Embodiment]

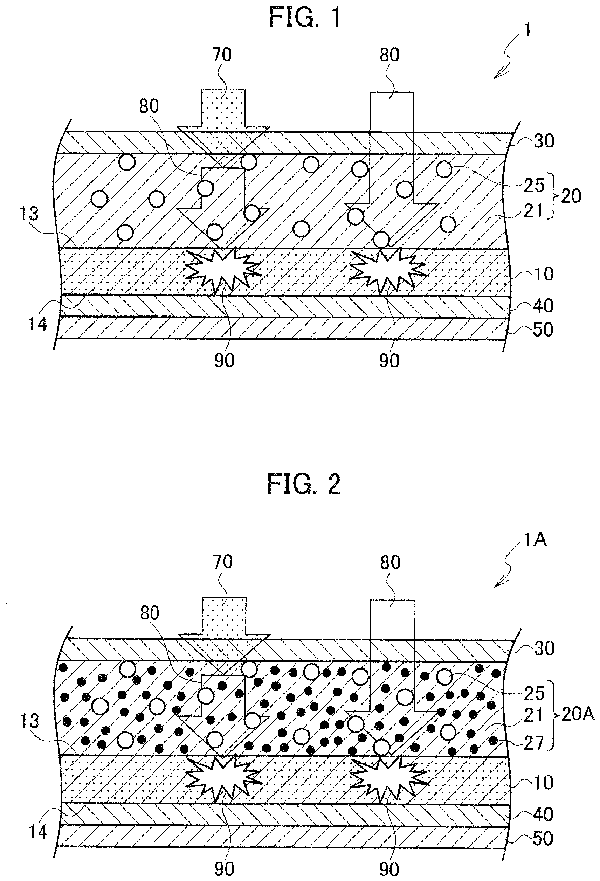

FIG. 1 is a cross-sectional view schematically showing a solar cell module as a photovoltaic device according to a first embodiment. As shown in FIG. 1, a solar cell module 1 includes: a solar cell 10 as a photoelectric conversion element; a wavelength conversion member 20 disposed on a light receiving surface 13 side of the solar cell 10; and a surface protection layer 30 disposed on a surface of the wavelength conversion member 20. The solar cell module 1 further includes: a back surface sealing member 40 disposed on a back surface 14 that is a surface opposite with the light receiving surface 13 among surfaces of the solar cell 10; and a back surface protection layer 50 disposed on a back surface of the back surface sealing member 40. That is, the solar cell module 1 has a configuration in which the surface protection layer 30, the wavelength conversion member 20, the solar cell 10, the back surface sealing member 40 and the back surface protection layer 50 are provided in this order from above in the drawing. The solar cell module 1 is configured to generate photovoltaic power in such a manner that light made incident from a light incident surface 33 that is a surface of the surface protection layer 30 is received directly by the solar cell 10 or received thereby after being converted by the wavelength conversion member 20.

### (Solar cell)

The solar cell 10 absorbs the light made incident from the light receiving surface 13 of the solar cell 10, and generates the photovoltaic power. The solar cell 10 is formed, for example, by using a semiconductor material such as crystalline silicon, gallium arsenide (GaAs), indium phosphide (InP), and the like. Specifically, the solar cell 10 is formed, for example, by laminating the crystalline silicon and amorphous silicon. Electrodes (not shown) are provided on the light receiving surface 13 of the solar cell 10 and on the back surface 14 that is the surface opposite with the light receiving surface 13. The photovoltaic power generated in the solar cell 10 is supplied to the outside via the electrodes.

### (Wavelength conversion member)

The wavelength conversion member 20 is disposed on the light receiving surface 13 of the solar cell 10. As shown in FIG. 1, the wavelength conversion member 20 includes: a sealing material 21 that seals the light receiving surface 13 of the solar cell 10; and a phosphor 25 dispersed in the sealing material 21. The wavelength conversion member 20 prevents moisture from entering the solar cell 10 by the sealing material 21, and enhances strength of the entire solar cell module 1 thereby. Moreover, by the phosphor 25, the wavelength conversion member 20 converts a part of light, which passes through the wavelength conversion member 20, into light on a long wavelength side. Furthermore, since the sealing material 21 and the phosphor 25 are those described below in detail, the wavelength conversion member 20 has high transmittance for the visible light and the infrared light in a wavelength region where photoelectric conversion efficiency of the solar cell is high. The wavelength conversion member 20 is a sheet-shaped body, a film-shaped body, or a plate-shaped body, which is disposed on the surface of the solar cell 10. Although a thickness of the wavelength conversion member is not particularly limited, for example, the thickness is preferably 0.2 to 1 mm since such a wavelength conversion member can then be formed, which is capable of sufficiently absorbing the ultraviolet light without lowering the transmittance for the visible light and the infrared light.

### (Sealing material)

As the sealing material 21, for example, there can be used a transparent resin such as an ethylene-vinyl acetate copolymer (EVA), polyvinyl butyral (PVB), polyimide, polyethylene, polypropylene, and polyethylene terephthalate (PET). Refractive indices of these transparent resins are 1.41 or more to less than 1.57.

### <Phosphor>

An inorganic phosphor is used as the phosphor 25. In general, the inorganic phosphor has a crystal structure in which a light emission center that emits fluorescence is partially substituted for a part of atoms which constitute a host crystal made of an inorganic compound. The inorganic phosphor for use in this embodiment has a crystal structure, in which at least one of Ce³⁺ and Eu²⁺, which is the light emission center, is substituted for a part of a host crystal that contains at least one of an alkaline earth metal element and a rare earth element and does not contain the alkaline metal element. Hereinafter, a description will be made of the crystal structure of the phosphor 25 and the light emission center included in the crystal structure.

### [Crystal structure]

In the case of containing the alkaline earth metal element, the phosphor contains one or more elements, which are selected from the group consisting of Ca, Sr and Ba, as the alkaline earth metal element. Moreover, in the case of containing the rare earth element, the phosphor contains one or more elements selected from the group consisting of La, Ce, Pr, Nd, Pm, Sm, Eu, Gd, Tb, Dy, Ho, Er, Tm, Yb, Lu, Sc and Y. In this description, the rare earth element means 17 elements obtained by adding Sc and Y to 15 lanthanoid elements La to Lu.

Since the phosphor is a crystal containing at least one of the alkaline earth metal element and the rare earth element, Ce³⁺ or Eu²⁺, which serves as the light emission center, can be contained in a large amount in the structure of the phosphor, and accordingly, the phosphor is preferable since the phosphor becomes capable of sufficiently absorb the ultraviolet light. The alkaline earth metal element in the host crystal is easily substituted with Ce³⁺ or Eu²⁺, which is the light emission center. Therefore, when the phosphor contains the alkaline earth metal element, the phosphor contains a large amount of Ce³⁺ or Eu²⁺ in the crystal structure, whereby an ultraviolet light absorption rate of the phosphor 25 increases.

Moreover, it is preferable that the phosphor containing the alkaline earth metal element be a fluoride containing the alkaline earth metal element and magnesium since good temperature quenching characteristics are brought, that is, it becomes easy to increase quantum efficiency thereof in addition to high light emission intensity even at high temperature. Note that a reason why the temperature quenching characteristics are improved is presumed as follows. That is, in general, a crystal structure of the above-described fluoride becomes a strong host crystal in which a large number of [MgF₆]⁴⁻ units with an octahedral structure are bonded to one another while sharing F. Then, a phosphor, which is composed in such a manner that Ce³⁺ or Eu²⁺ as the light emission center is substituted for a part of this strong host crystal, has a strong crystal structure, and accordingly, Ce³⁺ or Eu²⁺ as the light emission center becomes hard to vibrate. When Ce³⁺ or Eu²⁺ as the light emission center is hard to vibrate, the light emission is stably performed even if the temperature of the phosphor rises. Accordingly, it is presumed that the phosphor composed of the fluoride containing the alkaline earth metal element and magnesium has good temperature quenching characteristics.

When the phosphor composed of the fluoride has a crystal structure, in which at least one of Ce³⁺ and Eu²⁺ is substituted for a part of atoms constituting a host crystal having a composition represented by the following formula (1), then this is preferable since the phosphor has high absorption rate and quantum efficiency and good temperature quenching characteristics:

M₃Mg₄F₁₄ (1)

(where M is at least one alkaline earth metal element selected from the group consisting of Ca, Sr and Ba.).

The crystal structure, in which at least one of Ce³⁺ and Eu²⁺ is substituted for a part of the atoms of the host crystal having the composition represented by the above-described formula (1), is represented, for example, by the following formula (2) or (3). That is, the composition of the phosphor composed of the fluoride is represented, for example, by the following formula (2) or (3):

(M₁₋ₓCeₓ)₃Mg₄F₁₄ (2)

(where M is at least one alkaline earth metal element selected from the group consisting of Ca, Sr and Ba, and x is a number satisfying 0 < x < 0.3.)

(M_{1-y}Eu_{y})₃Mg₄F₁₄ (3)

(where M is at least one alkaline earth metal element selected from the group consisting of Ca, Sr and Ba, and y is a number satisfying 0 < y < 0.3.).

In formula (2), x is preferably 0.003 ≤ x ≤ 0.1, more preferably 0.01 ≤ x 0.1. Moreover, in formula (3), y is preferably 0.003 ≤ y ≤ 0.1, more preferably 0.01 ≤ y ≤ 0.1.

When the host crystal of the fluoride has a composition in which O is substituted for a part of F in the above-described formula (1), a refractive index of the phosphor composed of the fluoride tends to become higher than that of the phosphor having the host crystal having the composition represented by the above-described formula (1). Specifically, when the host crystal of the fluoride has, for example, a composition represented by the following formula (4), it is easy to obtain a phosphor having a higher refractive index. With regard to a phosphor having a crystal structure in which a host crystal has a composition represented by the following formula (4) and in which at least one of Ce³⁺ and Eu²⁺ is substituted for a part of atoms constituting the host crystal, a refractive index thereof tends to be high:

M₃Mg₄F₁₄₋ₐOₐ (4)

(where M is at least one alkaline earth metal element selected from the group consisting of Ca, Sr and Ba, and a is a number satisfying 0 ≤ a ≤ 3.).

The above-described formula (4) is the same as the above-described formula (1) except that F₁₄ is changed to F₁₄₋ₐOₐ. In the above-described formula (4), a is preferably 0.5 ≤ a ≤ 2, more preferably 0.8 ≤ a ≤ 1.2. When a stays within this range, then this is preferable since it is easy to obtain such a phosphor having a high refractive index.

A composition of such a phosphor, which is composed of a fluoride and has a crystal structure, in which at least one of Ce³⁺ and Eu²⁺ is substituted for a part of atoms of a host crystal having a composition represented by the above-described formula (4), is represented, for example, by the following formula (5) or (6):

(M₁₋ₓCeₓ)₃Mg₄F_{14-b}O_{b} (5)

(where M is at least one alkaline earth metal element selected from the group consisting of Ca, Sr and Ba, x is a number satisfying 0 < x < 0.3, and b is a number satisfying 0 < b ≤ 3.).

The above-described formula (5) is the same as the above-described formula (2) except that F₁₄ is changed to F_{14-b}O_{b}. In the above-described formula (5), b is preferably 0.5 ≤ b ≤ 2, more preferably 0.8 ≤ b ≤ 1.2. When b stays within this range, then this is preferable since it is easy to obtain such a phosphor having a higher refractive index.

(M_{1-y}Eu_{y})₃Mg₄F)_{14-c}O_{c} (6)

(where M is at least one alkaline earth metal element selected from the group consisting of Ca, Sr and Ba, y is a number satisfying 0 < y < 0.3, and c is a number satisfying 0 < c ≤ 3.).

The above-described formula (6) is the same as the above-described formula (3) except that F₁₄ is changed to F_{14-c}O_{c}. In the above-described formula (6), c is preferably 0.5 ≤ c ≤ 2, more preferably 0.8 ≤ c ≤ 1.2. When c stays within this range, then this is preferable since it is easy to obtain such a phosphor having a higher refractive index.

In the phosphor composed of the fluoride, a 10% diameter D₁₀ is preferably 15 µm or more. When the 10% diameter D₁₀ of the fluoride stays within this range, then this is preferable since there rises the transmittance of the wavelength conversion member for the visible light and the infrared light. Moreover, in the phosphor composed of the fluoride, a median diameter of the fluoride is preferably less than 1000 µm. When the median diameter of the fluoride stays within this range, then this is preferable since the absorption rate of the wavelength conversion member for the ultraviolet light rises. Moreover, in the phosphor composed of the fluoride, preferably, D₁₀ is 15 µm or more, and the median diameter is less than 1000 µm. When the 10% diameter D₁₀ and median diameter of the fluoride stay within these ranges, then this is preferable since such a wavelength conversion member is obtained, in which the absorption rate for the ultraviolet light is high, and the transmittance for the visible light and the infrared light is high.

Note that the phosphor, which has the crystal structure in which Eu²⁺ or the like is substituted for a part of the atoms of the host crystal having the composition represented by the above-described formula (1), is usually produced by using a fluoride of each of the alkaline earth metal, magnesium, cerium and europium as a raw material. Hereinafter, these fluorides are referred to as "fluoride raw materials". The phosphor, which has the crystal structure in which Eu²⁺ or the like is substituted for a part of the atoms of the host crystal having the composition in which O is substituted for a part of F in the above-described formula (1), can be produced, for example, by using such a fluoride raw material as described above and using a raw material in which oxygen is substituted for fluorine in the fluoride raw material. As the raw material in which oxygen is substituted for fluorine in the fluoride raw material, for example, there are used oxides, carbonates, nitrates, oxalates, sulfates, acetates and hydroxides of the alkaline earth metal, magnesium, cerium and europium.

Note that the phosphor for use in this embodiment does not contain an alkaline metal element. Here, the alkaline metal element is H, Li, Na, K, Rb, Cs and Fr. Moreover, the phrase "the phosphor does not contain an alkaline metal element" means that the alkaline metal element contained in the phosphor is less than 1 mol%. Since the phosphor for use in this embodiment does not contain the alkaline metal element, the phosphor has light emission characteristics unchanged even if coming into contact with moisture, and has excellent reliability. That is, when a phosphor containing a general alkaline metal element comes into contact with moisture, then the alkaline metal element in the phosphor reacts with moisture, the composition of the phosphor is changed, and the light emission characteristics of the phosphor are changed. Since the phosphor for use in this embodiment does not contain the alkaline metal element, the phosphor has light emission characteristics unchanged even if coming into contact with moisture, and has excellent reliability.

The phosphor may contain halogen elements other than fluorine, that is, Cl, Br, I and the like within a range where the crystal structure of the phosphor is not damaged. When the phosphor contains these halogen elements, it becomes possible to control shapes of an excitation spectrum and a light emission spectrum, which are derived from Eu²⁺ and Ce³⁺, and to control the refractive index of the phosphor. Moreover, the phosphor may contain oxygen O within the range where the crystal structure of the phosphor is not damaged. When the phosphor contains oxygen O, it becomes possible to control the shapes of the excitation spectrum and the light emission spectrum, which are derived from Eu²⁺ and Ce³⁺, and to control the refractive index of the phosphor.

The phosphor may contain rare earth elements other than Eu²⁺ and Ce³⁺ within the range where the crystal structure of the phosphor is not damaged. When the phosphor contains these rare earth elements, then the phosphor becomes capable of containing a large amount of the light emission center element, and the absorption rate of the ultraviolet light can be enhanced.

The phosphor may contain an element, which is capable of taking a hexacoordinated state, within the range where the crystal structure of the phosphor is not damaged, the element being other than Mg and containing at least one element, for example, selected from the group consisting of A1, Ga, Sc, Zr, Mn and Lu. When the phosphor contains such an element as described above, then the refractive index of the phosphor can be controlled.

The phosphor may have the same crystal structure as Pb₃Nb₄O₁₂F₂. When the phosphor has such a type of the crystal structure, then the phosphor can be obtained, which has high absorption rate and quantum efficiency and good temperature quenching characteristics.

The phosphor may be one using Ba₂(Ca₁₋ₓSrₓ)Mg₄F₁₄ (where x is a number satisfying 0 ≤ x ≤ 1) as a host crystal. When the phosphor is composed of such a type of the host crystal, then the phosphor can be obtained, which has high absorption rate and quantum efficiency and good temperature quenching characteristics. Moreover, when the phosphor is composed of such a host crystal as described above, it becomes easy to adjust the refractive index of the phosphor.

The phosphor may be one using Ba_{2+y}(Ca₁₋ₓSrₓ)]_{1-y}Mg₄F₁₄ (where x is a number satisfying 0 ≤ x ≤ 1, and y is a number satisfying 0 ≤ y ≤ 1) as a host crystal. When the phosphor is composed of such a host crystal as described above, it becomes easy to adjust the refractive index of the phosphor.

### [Light emission center]

As described above, the phosphor 25 has the crystal structure, in which at least one of Ce³⁺ and Eu²⁺, which is the light emission center, is substituted for a part of a host crystal that contains at least one of the alkaline earth metal element and the rare earth element and does not contain the alkaline metal element. The phosphor 25 contains at least one of Ce³⁺ and Eu²⁺ as the light emission center, and accordingly, the composition of the host crystal is adjusted, whereby it becomes possible to obtain such an inorganic phosphor that absorbs the ultraviolet light having a wavelength of 300 to 400 nm, the ultraviolet light damaging the solar cell 10 and having poor power generation efficiency.

Note that, in general inorganic phosphors, those using rare earth ions other than Ce³⁺ and Eu²⁺ as the light emission center are also known. However, when the light emission center is the rare earth ions other than Ce³⁺ and Eu²⁺, even if the composition of the host crystal is adjusted, it is difficult to obtain an inorganic phosphor that absorbs the ultraviolet light having a wavelength of 300 to 400 nm. A reason why it is possible to obtain the inorganic phosphor that absorbs the ultraviolet light having a wavelength of 300 to 400 mm by adjusting the composition of the host crystal as described above when the phosphor of this embodiment contains at least one of Ce³⁺ and Eu²⁺ as the light emission center is presumed as follows.

Among the rare earth ions, rare earth ions of Ce to Yb have electrons in a 4f orbital. The absorption and emission of light, which are derived from the rare earth ions, are classified into two types, which are: transition in a 4f shell; and transition between a 5d shell and the 4f shell.

The ions other than Ce³⁺ and Eu²⁺ among the rare earth ions generally absorb and emit light by the transition in the 4f shell. However, in the transition in the 4f shell, the electrons in the 4f orbital are present in an inside of electrons of a 5s orbital and a 5p orbital and are shielded, and accordingly, fluctuation of an energy level due to an influence of an environment around the phosphor are less likely to occur. Therefore, in the inorganic phosphor that uses the ions other than Ce³⁺ and Eu²⁺ as the light emission center, even if the composition of the host crystal is adjusted, the change of the light emission wavelength is small, and it is difficult to obtain the inorganic phosphor that absorbs the ultraviolet light having a wavelength of 300 to 400 nm.

In contrast, Ce³⁺ and Eu²⁺ perform the absorption and emission of light by the transition between the 5d shell and the 4f shell, that is, transition between 4fⁿ and 4fⁿ⁻¹5d. In this transition between the 5d shell and the 4f shell, the 5d orbital is not shielded from other orbits, and accordingly, the fluctuation of the energy level of the 5d orbital due to the influence of the environment around the phosphor is likely to occur. Therefore, in the inorganic phosphor that uses Ce³⁺ and Eu²⁺ as the light emission center, in the case of light emission that is based on the transition from the 4fⁿ⁺¹5d¹ level to the 4f orbital, it becomes possible to greatly change the light emission wavelength by adjusting the composition of the host crystal. Due to this great change of the light emission wavelength, in accordance with the inorganic phosphor that uses Ce³⁺ and Eu²⁺ as the light emission center, it becomes possible to obtain the inorganic phosphor, which absorbs the ultraviolet light having a wavelength of 300 to 400 nm.

The phosphor 25 may further contain Mn²⁺. When the phosphor further contains Mn²⁺, energy transfer from Ce³⁺ or Eu²⁺ to Mn²⁺ occurs, which makes it possible to shift the light emission, which is originated from the phosphor, to a longer wavelength side.

### [Light emission spectrum]

In the phosphor 25, a light emission spectrum measured at room temperature has a light emission peak derived from at least one of Ce³⁺ and Eu²⁺ within a wavelength range of 440 nm or more to less than 1200 nm. Here, "room temperature" means 21 to 25°C. Since the light emission peak derived from at least one of Ce³⁺ and Eu²⁺ exhibits the maximum intensity value of the light emission spectrum, the phosphor 25 exhibits much light emission in a wavelength region where spectral sensitivity of the solar cell is high.

Here, the light emission peak derived from Ce³⁺ means a light emission peak, in which Ce³⁺ is involved in the light emission, among light emission peaks included in the light emission spectrum of the Ce³⁺-activated phosphor containing at least Ce³⁺ as the light emission center. Specifically, the light emission peak derived from Ce³⁺ has a meaning including both of a light emission peak intrinsic to Ce³⁺ and a peak of a light emission component of Ce³⁺ in a light emission peak of a complex shape formed of a plurality of light emission components which are based on plural types of light emission centers. For example, in such a Ce³⁺-activated phosphor containing only Ce³⁺ as the light emission center, a light emission peak (A) intrinsic to Ce³⁺ appears within a specific wavelength region of the light emission spectrum. Meanwhile, in such a Ce³⁺-activated phosphor in which there coexist Ce³⁺ and other light emission center such as Mn²⁺, a light emission peak of a complex shape appears, which combines a peak (B1) of the light emission component of Ce³⁺ and a peak (B2) of the light emission component of the other light emission center with each other, in the light emission spectrum. The peak (B1) of the light emission component of Ce³⁺ in the light emission peak of the complex shape appears in or near a specific wavelength region of the light emission peak (A) intrinsic to Ce³⁺. The light emission peak derived from Ce³⁺, which is defined in this description, is a concept including the light emission peak (A) intrinsic to Ce³⁺ and the peak (B1) of the light emission component of Ce³⁺. Note that the peak (B2) of the light emission component at the other light emission center in the light emission peak of the complex shape is referred to as a peak of the light emission component of Mn²⁺ when the other light emission center is Mn²⁺.

The light emission peak of the complex shape including the peak of the light emission component of Ce³⁺ will be described. In the light emission spectrum of the phosphor containing Ce³⁺, the light emission spectrum intrinsic to Ce³⁺, which is observed when only Ce³⁺ is contained as the light emission center, and the light emission spectrum observed when Ce³⁺ and the other light emission center such as Mn²⁺ coexist may sometimes be different in shape from each other. This is because the light emission spectrum of the former case includes only the light emission peak (A) intrinsic to Ce³⁺, whereas the light emission spectrum of the latter case includes the light emission peak of the complex shape, which combines the peak (B1) of the light emission component of Ce³⁺ and the peak (B2) of the light emission component of the other light emission center with each other. The light emission peak of the complex shape is formed, for example, in such a manner that energy is transferred from Ce³⁺ to the other light emission center such as Mn²⁺.

Moreover, the light emission peak derived from Eu²⁺ means a light emission peak, in which Eu²⁺ is involved in the light emission, among light emission peaks included in the light emission spectrum of the Eu²⁺ -activated phosphor containing at least Eu²⁺ as the light emission center. Specifically, the light emission peak derived from Eu²⁺ has a meaning including both of a light emission peak intrinsic to Eu²⁺ and a peak of a light emission component of Eu²⁺ in a light emission peak of a complex shape formed of a plurality of light emission components which are based on plural types of light emission centers. For example, in such a Eu²⁺-activated phosphor containing only Eu²⁺ as the light emission center, a light emission peak (C) intrinsic to Eu²⁺ appears within a specific wavelength region of the light emission spectrum. Meanwhile, in such a Eu²⁺-activated phosphor in which there coexist Eu²⁺ and other light emission center such as Mn²⁺, a light emission peak of a complex shape appears, which combines a peak (D1) of the light emission component of Eu²⁺ and a peak (D2) of the light emission component of the other light emission center with each other, in the light emission spectrum. The peak (D1) of the light emission component of Eu²⁺ in the light emission peak of the complex shape appears in or near a specific wavelength region of the light emission peak (C) intrinsic to Eu²⁺. The light emission peak derived from Eu²⁺, which is defined in this description, is a concept including the light emission peak (C) intrinsic to Eu²⁺ and the peak (D1) of the light emission component of Eu²⁺. Note that the peak (D2) of the light emission component at the other light emission center in the light emission peak of the complex shape is referred to as a peak of the light emission component of Mn²⁺ when the other light emission center is Mn²⁺.

The light emission peak of the complex shape including the peak of the light emission component of Eu²⁺ will be described. In the light emission spectrum of the phosphor containing Eu²⁺, the light emission spectrum intrinsic to Eu²⁺, which is observed when only Eu²⁺ is contained as the light emission center, and the light emission spectrum observed when Eu²⁺ and the other light emission center such as Mn²⁺ coexist may sometimes be different in shape from each other. This is because the light emission spectrum of the former case includes only the light emission peak (C) intrinsic to Eu²⁺, whereas the light emission spectrum of the latter case includes the light emission peak of the complex shape, which combines the peak (C1) of the light emission component of Eu²⁺ and the peak (D2) of the light emission component of the other light emission center with each other. The light emission peak of the complex shape is formed, for example, in such a manner that energy is transferred from Eu²⁺ to the other light emission center such as Mn²⁺.

In the phosphor 25, a light emission spectrum measured at room temperature has a light emission peak derived from at least one of Ce³⁺ and Eu²⁺, which are described above, within a wavelength range of 440 nm or more to less than 1200 nm, and this light emission peak exhibits a maximum intensity value of the above-described light emission spectrum. That is, the light emission peak of the light emission spectrum derived from at least one of Ce³⁺ and Eu²⁺ exhibits the maximum intensity value within the wavelength range of 440 nm or more to less than 1200 nm. The light emission peak of the light emission spectrum derived from at least one of Ce³⁺ and Eu²⁺ exhibits the maximum intensity value within the above wavelength region, and accordingly, it is understood that the phosphor for use in this embodiment is a phosphor, which does not include light emission by impurities and the like, and has high light emission efficiency. The fact that the light emission peak of the light emission spectrum derived from at least one of Ce³⁺ and Eu²⁺ exhibits the maximum intensity value within the above-described wavelength region can be achieved by adjusting the crystal structure of the phosphor. In accordance with the phosphor of this embodiment, it is possible to convert the ultraviolet light into light in a longer wavelength region in which spectral sensitivity of the solar cell is high.

### [Excitation spectrum]

In the phosphor 25, it is preferable that an excitation spectrum have light absorption, which is brought by at least one of Ce³⁺ and Eu²⁺, within a wavelength range of 300 nm or more to less than 400 nm. Based on the excitation spectrum, it is understood that the phosphor for use in this embodiment has light absorption characteristics within such a wavelength range, and can convert the ultraviolet light having a wavelength from 300 nm or more to less than 400 nm, where the photoelectric conversion efficiency of the solar cell is low, into light in a wavelength region where the photoelectric conversion efficiency of the solar cell is high. That fact that the phosphor has the light absorption as described above can be achieved by adjusting the crystal structure of the phosphor.

It is preferable that the excitation spectrum be a spectrum that is based on electron energy transition of Eu²⁺. Here, the electron energy transition of Eu²⁺ means energy transition between an electronic ground state and an electronic excitation state. In general, the light emission spectrum and excitation spectrum of Eu²⁺ exhibit absorption and light emission on longer wavelength side than the light emission spectrum and excitation spectrum of Ce³⁺, respectively. Therefore, it is easy for the phosphor to absorb the ultraviolet light having a wavelength of 300 nm or more to less than 400 mm, and it becomes possible for the phosphor to exhibit light emission in such a region where the spectral sensitivity of the solar cell is higher.

### [Refractive index]

A refractive index of the phosphor 25 is 1.41 or more to less than 1.57, preferably 1.44 or more to less than 1.54, and more preferably 1.47 or more to less than 1.51. The refractive index of the phosphor stays within the above-described range, whereby a decrease of the transmittance of the wavelength conversion member 20 for the visible light and the infrared light when the phosphor is dispersed in the sealing material 21 can be suppressed.

### [Shape]

The shape of the phosphor 25 is preferably granular or powdery. When the phosphor is granular or powdery, the phosphor 25 is easy to be dispersed in the sealing material 21. When the phosphor is granular or powdery, then an average particle size is preferably 0.1 µm or more to less than 100 µm, more preferably 0.3 µm or more to less than 30 µm. When the average particle size of the phosphor stays within the above-described range, it becomes possible to manufacture a wavelength conversion member that sufficiently absorbs ultraviolet light and suppresses a decrease of transmittance of visible light and infrared light. The average particle size of the phosphor can be measured by observing a cross section of the wavelength conversion member by means of a scanning electron microscope. For example, the average particle size of the phosphor is defined as an average value of longest axis lengths in arbitrary 20 or more phosphor particles observed by means of a scanning electron microscope.

Here, a description will be made of relationships between a refractive index of the sealing material 21 and the refractive index and particle size of the phosphor 25 in the wavelength conversion member 20.

In general, when the wavelength conversion member disposed on the surface of the solar cell is a sheet shape member or a film shape member in which the phosphor is dispersed in the sealing material, then it is necessary to take measures for preventing the transmittance of the wavelength conversion member for the visible light and the infrared light from being lowered.

Specifically, when a difference in refractive index between the sealing material and the phosphor is large, it is necessary to reduce the average particle size of the phosphor to approximately several tens of nanometers. This is because, since the visible light and the infrared light, which are made incident onto the sealing material of the wavelength conversion member, are scattered on the surface of the phosphor and hardly transmit through the phosphor when the difference in refractive index between the sealing material and the phosphor is large, it is necessary to reduce the particle size of the phosphor so as to reduce an influence of the scattering of the visible light and the infrared light.

Meanwhile, when the difference in refractive index between the sealing material and the phosphor is small, even if the phosphor has an average particle size as large as approximately several tens of micrometers, the phosphor concerned can be used. This is because the visible light and the infrared light, which are made incident onto the sealing material of the wavelength conversion member, are hardly scattered on the surface of the phosphor, and is sufficiently transmittable through the phosphor.

In the wavelength conversion member 20 for use in this embodiment, since the difference in refractive index between the sealing material 21 and the phosphor 25 is small, it is possible to use phosphor powder having a relatively large particle size as described above.

### (Production of phosphor)

The phosphor 25 can be produced by a publicly known method such as a solid phase reaction. An example of the solid phase reaction is shown below.

First, raw material powders of an oxide, a fluoride and the like are prepared. Next, the raw material powders are compounded so as to have a stoichiometric composition of a compound as a production target or a composition close to the stoichiometric composition, and are mixed thoroughly by using a mortar, a ball mill or the like. Thereafter, such a mixed raw material is baked by an electric furnace or the like while using a baking vessel such as an alumina crucible, whereby the phosphor of this embodiment can be prepared. Note that, when the mixed raw material is baked, it is preferable to bake the mixed raw material at 700 to 1000°C for several hours in the atmosphere or a weak reducing atmosphere. Moreover, an additive such as a reaction accelerator may be added to the raw materials of the phosphor. Moreover, when the host of the phosphor is a fluoride, it is preferable to use NH₄F, which suppresses desorption of fluorine, as an additive.

### [Effect of phosphor]

At room temperature or higher, the phosphor 25 for use in this embodiment can absorb the ultraviolet light having a wavelength of 300 to 400 nm, and can convert the ultraviolet light into the visible light or the infrared light, which stay within a wavelength range of 440 nm or more to less than 1200 nm. Moreover, the phosphor 25 for use in this embodiment has a small difference in refractive index from the sealing material 21 of the wavelength conversion member 20, has the light emission characteristics unchanged even if coming into contact with moisture, and has high reliability. Therefore, the phosphor 25 for use in this embodiment is suitable for the wavelength conversion member 20 of the solar cell module 1.

### <Blending ratio of sealing material and phosphor>

When the wavelength conversion member 20 is taken as 100 vol%, the wavelength conversion member 20 usually contains the phosphor 25 by an amount of 0.1 vol% or more to less than 10 vol%, preferably 1 vol% or more to less than 5 vol%. When a content of the phosphor stays within the above-described range, such a wavelength conversion member is obtained, which sufficiently absorbs the ultraviolet light and suppresses the decrease of the transmittance of the visible light and the infrared light.

### <Manufacturing method of wavelength conversion member>

The wavelength conversion member 20 can be manufactured by mixing the phosphor 25 with the sealing material 21 and molding an obtained mixture into sheet form, a film form, a plate form, or the like.

### <Function of wavelength conversion member>

A function of the wavelength conversion member 20 will be described with reference to FIG. 1. When the solar cell module 1 is irradiated with sunlight including ultraviolet light 70, visible light and infrared light 80, the ultraviolet light 70, the visible light and the infrared light 80 pass through the surface protection layer 30, and is made incident onto the wavelength conversion member 20. The visible light and the infrared light 80, which are made incident onto the wavelength conversion member 20, pass as they are through the wavelength conversion member 20 without being converted substantially by the phosphor 25, and then are applied to the solar cell 10. Meanwhile, the ultraviolet light 70 made incident onto the wavelength conversion member 20 is converted into the visible light and the infrared light 80, which are light on the long wavelength side, by the phosphor 25, and thereafter, are applied to the solar cell 10. The solar cell 10 generates photovoltaic power 90 by the applied visible light and infrared light 80, and the photovoltaic power 90 is supplied to the outside of the solar cell module 1 via the terminals which are not shown.

### <Effect of wavelength conversion member>

At room temperature or higher, the wavelength conversion member 20 for use in this embodiment can absorb the ultraviolet light having a wavelength of 300 to 400 nm, and can convert the ultraviolet light into the visible light and the infrared light, which stay within a wavelength range of 440 nm or more to less than 1200 nm. Moreover, the wavelength conversion member 20 for use in this embodiment has such a small refractive index difference between the phosphor 25 and the sealing material 21, and accordingly, has high transmittance for the above-described visible light and infrared light. Furthermore, the wavelength conversion member 20 for use in this embodiment has the light emission characteristics unchanged even if the phosphor contained in the wavelength conversion member 20 comes into contact with moisture, and accordingly, has high reliability. Therefore, the wavelength conversion member 20 for use in this embodiment is suitable for the solar cell module of the solar cell module 1.

### (Surface protection layer)

The surface protection layer 30 disposed on the surface of the wavelength conversion member 20 protects the wavelength conversion member 20 and the solar cell 10 from the external environment of the solar cell module 1. Moreover, the surface protection layer 30 may have a filtering function that does not transmit light in a specific wavelength region according to needs. For example, the surface protection layer 30 is made of a glass substrate, polycarbonate, acrylic, polyester, polyethylene fluoride and the like.

### (Back surface sealing member)

The back surface sealing member 40 disposed on the back surface 14 of the solar cell 10 prevents moisture from entering the solar cell 10, and enhances the strength of the entire solar cell module 1. For example, the back surface sealing member 40 is made of the same material as such a material that can be used for the sealing material 21 of the wavelength conversion member 20. The material of the back surface sealing member 40 may be the same as or different from the material of the sealing material 21 of the wavelength conversion member 20.

### (Back surface protection layer)

The back surface protection layer 50 disposed on the back surface of the back surface sealing member 40 protects the back surface sealing member 40 and the solar cell 10 from the external environment of the solar cell module 1. For example, the back surface protection layer 50 is made of the same material as such a material that can be used for the surface protection layer 30. The material of the back surface protection layer 50 may be the same as or different from the material of the surface protection layer 30.

### (Function of solar cell module)

The function of the solar cell module 1 has been described in the section on the function of the wavelength conversion member 20, a description thereof is omitted.

### (Effect of solar cell module as photovoltaic device)

The solar cell module 1 as the photovoltaic device according to this embodiment can absorb the ultraviolet light having the wavelength of 300 to 400 nm, and can convert the ultraviolet light into the visible light and the infrared light, which stay within the wavelength range of 440 nm or more to less than 1200 nm, at room temperature or higher. Moreover, the solar cell module 1 has high transmittance for the visible light and the infrared light in the wavelength conversion member 20. Therefore, the solar cell module 1 has high photoelectric conversion efficiency. Furthermore, the solar cell module 1 has light emission characteristics unchanged even if the phosphor contained in the wavelength conversion member 20 comes into contact with moisture, and accordingly, has high reliability.

### [Second Embodiment]

FIG. 2 is a cross-sectional view schematically showing a solar cell module as a photovoltaic device according to a second embodiment. A solar cell module 1A shown as the second embodiment in FIG. 2 is different from the solar cell module 1 shown as the first embodiment in FIG. 1 in that a wavelength conversion member 20A is used instead of the wavelength conversion member 20, and other configurations of the solar cell module 1A and the solar cell module 1 are the same therebetween. Therefore, the same reference numerals are assigned to the same constituents between the solar cell module 1A shown in FIG. 2 and the solar cell module 1 shown in FIG. 1, and descriptions of a structure and function thereof are omitted or simplified.

### (Wavelength conversion member)

As shown in FIG. 2, a wavelength conversion member 20A includes: the sealing material 21 that seals the light receiving surface 13 of the solar cell 10; the phosphor 25 dispersed in the sealing material 21; and a scattering material 27 dispersed in the sealing material 21. That is, the wavelength conversion member 20 A of the solar cell module 1A shown in FIG. 2 differs from the wavelength conversion member 20 of the solar cell module 1 shown in FIG. 1 in that the sealing material 21 further includes the scattering material 27, and other configurations of the wavelength conversion member 20A are the same as those of the wavelength conversion member 20. Therefore, the same reference numerals are assigned to the same constituents between both, and descriptions of a structure and function thereof are omitted or simplified.

### <Scattering material>

The scattering material 27 is a substance having property of scattering light with an excitation wavelength of the phosphor 25 more than the light with the light emission wavelength of the phosphor 25. Here, the property of scattering the light with the excitation wavelength of the phosphor 25 more than the light with the light emission wavelength of the phosphor 25 means that such light transmittance of the scattering material 27 in the light emission wavelength region of the phosphor 25 is relatively higher than the light transmittance of the scattering material 27 in the excitation wavelength region of the phosphor 25. Moreover, the scattering material 27 has wavelength dependence of scattering characteristics. Here, the wavelength dependence means that only light having a short wavelength among light with all the wavelengths to be measured is strongly scattered, resulting in the decrease of the transmittance. Moreover, as the light having a short wavelength among the light with all the wavelengths to be measured, for example, light in the excitation wavelength region of the phosphor 25 is mentioned. Furthermore, as light having a longer wavelength than the light having a longer wavelength among the light with all the wavelengths to be measured, for example, light in the light emission wavelength region of the phosphor 25 is mentioned.

The wavelength dependence has variations in magnitude. The fact that the wavelength dependence is large means that, when only the light having a short wavelength among the light with all the wavelengths to be measured is strongly scattered, a degree of the scattering is large. Meanwhile, the fact that the wavelength dependence is small means that, when only the light having a short wavelength among light with all the wavelengths to be measured is strongly scattered, a degree of the scattering is small. Moreover, the wavelength dependence expresses "first wavelength characteristic" and "second wavelength characteristic", which will be described below.

In the scattering material 27, the light transmittance in the excitation wavelength region of the phosphor 25 is relatively lower than the light transmission in the light emission wavelength region. Therefore, when the scattering material 27 is present in the sealing material 21, the light in the excitation wavelength region of the phosphor 25 is scattered well by the scattering material 27, and becomes easy to be absorbed by the phosphor 25. Here, the excitation wavelength region of the phosphor 25 means a wavelength region having a wavelength of 400 nm or less. Therefore, it is preferable that the scattering material 27 scatter light having the wavelength of 400 nm or less, and it is more preferable that the scattering material 27 strongly scatter the light having a wavelength of 400 nm or less. Note that the fact that an absolute value of the light transmittance of the scattering material 27 in the excitation wavelength region of the phosphor 25 is low will be hereinafter referred to as "first wavelength characteristics".

Moreover, in the scattering material 27, the light transmittance in the light emission wavelength region of the phosphor 25 is relatively higher than the light transmission in the excitation wavelength region. Therefore, when the scattering material 27 is present in the sealing material 21, the light radiated from the phosphor 25 is efficiently absorbed by the solar cell 10, and the photoelectric conversion efficiency is increased. Note that the fact that an absolute value of the light transmittance of the scattering material 27 in the light emission wavelength region of the phosphor 25 is high will be hereinafter referred to as "second wavelength characteristics".

As described above, the scattering material 27 has property of scattering the light with the excitation wavelength of the phosphor 25 more than the light with the light emission wavelength of the phosphor 25. That is, the scattering material 27 has property in which the light transmittance of the scattering material 27 in the light emission wavelength region of the phosphor 25 is relatively higher than the light transmittance of the scattering material 27 in the excitation wavelength region of the phosphor 25. It is further preferable that the scattering material 27 have the first wavelength characteristics and the second wavelength characteristics, that is, that the absolute value of the light transmittance of the scattering material 27 be low in the excitation wavelength region of the phosphor 25, and that the light transmittance of the scattering material 27 in the light emission wavelength region of the phosphor 25 be high. When the scattering material 27 has the first wavelength characteristics and the second wavelength characteristics, then the light in the excitation wavelength region of the phosphor 25 is scattered well by the scattering material 27, and is easily absorbed by the phosphor 25, and the light radiated from the phosphor 25 is absorbed efficiently by the solar cell 10, resulting in the increase of the photoelectric conversion efficiency.

As a material of the scattering material 27, for example, silicon dioxide (SiO₂), zirconium oxide (IV) (ZrO₂) or the like is used. Among them, silicon dioxide is preferable since a refractive index thereof takes a value very close to the refractive index of the sealing material such as EVA, and the scattering of the light in the light emission wavelength region can be suppressed.

When the scattering material 27 is granular, this is preferable since the scattering material 27 becomes easy to be dispersed in the sealing material. Moreover, when the scattering material 27 is granular, and a size thereof at 50% D₅₀ is less than 400 nm, then this is preferable since it becomes difficult to scatter the light in the visible light region.

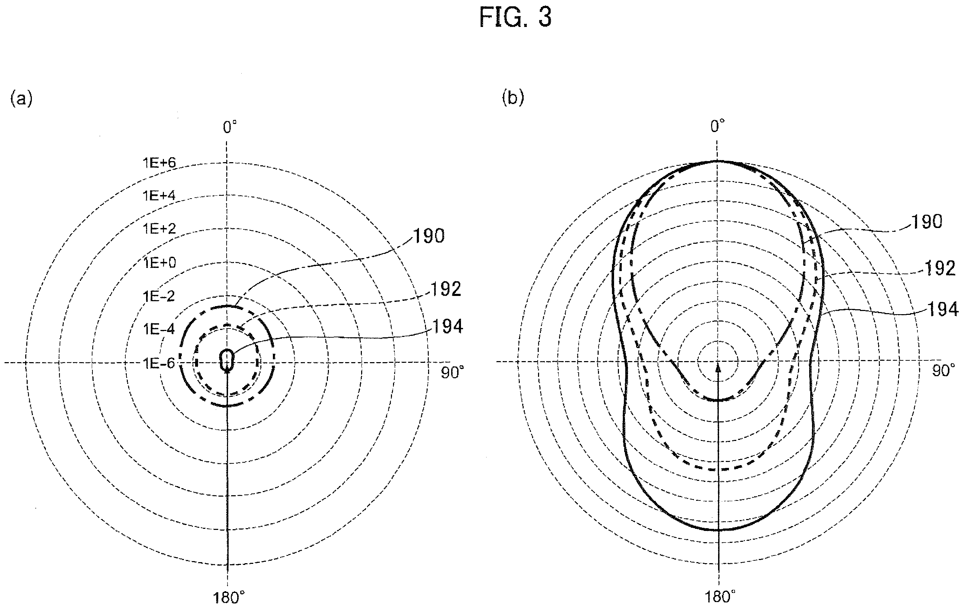

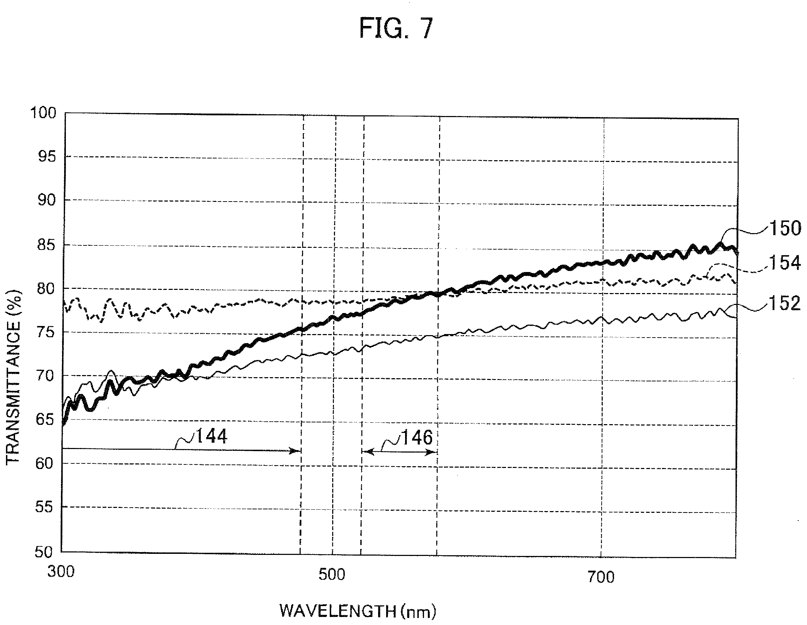

With regard to the scattering material 27, there were created: scattering intensity distributions of the scattering material when a simulation thereof was performed by setting the particle size of the scattering material 27 to a specific value; and scattering intensity distributions of the scattering material when a straight direction component of the scattering intensity was normalized to 1. The simulation was performed on the setting where light was made incident onto one particle of the scattering material. Moreover, a wavelength of the light to be applied in the simulation was set to 350 nm, 550 nm and 1000 nm. Note that the wavelength of 350 nm is a wavelength included in the excitation wavelength region of the phosphor 25, for example, included in an excitation wavelength region 144 of FIG. 7, which will be described later. Moreover, the wavelength of 550 nm is a wavelength included in the light emission wavelength region of the phosphor 25, for example, included in a light emission wavelength region 146 of FIG. 7, which will be described later. Furthermore, the wavelength of 1000 nm is a wavelength longer than the light emission wavelength of the phosphor 25. The above-described simulation was performed by setting the particle size of the scattering material 27 individually to 100 nm, 300 nm, 500 nm and 1000 nm. These results are shown in FIG. 3 to FIG. 6.

FIGS. 3A and 3B show scattering intensity distributions of the scattering material when the scattering intensity distributions were simulated by setting the particle size of the scattering material 27 to 100 nm, and show scattering intensity distributions of the scattering material when the straight direction component of the scattering intensity was normalized to 1. FIG. 3A shows scattering intensity distributions of the scattering material when the normalization was not performed, and FIG. 3B shows the scattering intensity distribution of the scattering material when the normalization was performed.

From FIG. 3A, it is understood that the direction dependence of the scattering intensity of the scattering material is low. Moreover, from FIG. 3A, it is understood that the scattering intensity of a simulation result 190 at the wavelength 350 nm is maximum, that the scattering intensity of a simulation result 192 at the wavelength of 550 nm is second largest, and that the scattering intensity of a simulation result 194 at the wavelength of 1000 nm is minimum. That is, it is understood that, as the wavelength becomes shorter, the scattering intensity of the scattering material becomes larger. Moreover, as shown in FIG. 3B, directivity of the simulation result 190 at the wavelength of 350 nm is larger than directivity of the simulation result 192 at the wavelength of 550 nm. Moreover, directivity of the simulation result 192 at the wavelength of 550 nm is larger than directivity of the simulation result 194 at the wavelength of 1000 nm. From these facts, it is understood that the directivity of the scattering intensity distribution of the scattering material is increased as the wavelength of the light applied to the scattering material becomes shorter. Note that, when the directivity of the scattering intensity distribution is increased, an occurrence rate of forward scattering by the scattering material is increased. Moreover, when the directivity of the scattering intensity distribution is decreased, an occurrence rate of back scattering by the scattering material is increased in addition to the forward scattering by the scattering material.

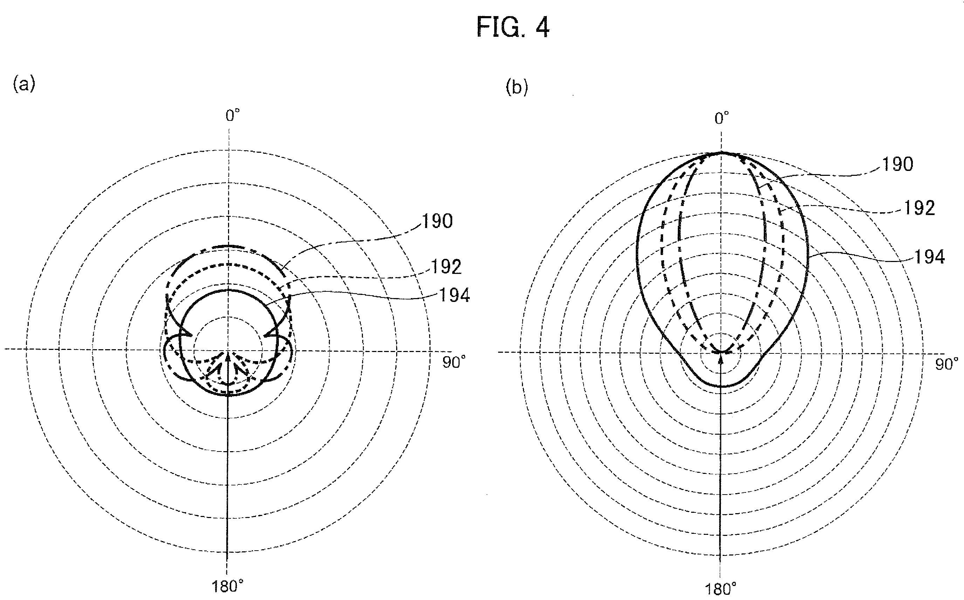

FIGS. 4A and 4B show scattering intensity distributions of the scattering material when the scattering intensity distributions were simulated by setting the particle size of the scattering material 27 to 300 nm, and show scattering intensity distributions of the scattering material when the straight direction component of the scattering intensity was normalized to 1. FIG. 4A shows scattering intensity distributions of the scattering material when the normalization was not performed, and FIG. 4B shows the scattering intensity distribution of the scattering material when the normalization was performed. When FIG. 4A and FIG. 3A are compared with each other, the scattering intensity becomes larger when the particle size of the scattering material 27 is 300 nm than when the particle size of the scattering material 27 is 100 nm. Moreover, when FIG. 4B and FIG. 3B are compared with each other, a difference in directivity, which depends on the wavelength, becomes smaller when the particle size of the scattering material 27 is 300 nm than when the particle size of the scattering material 27 is 100 mm.

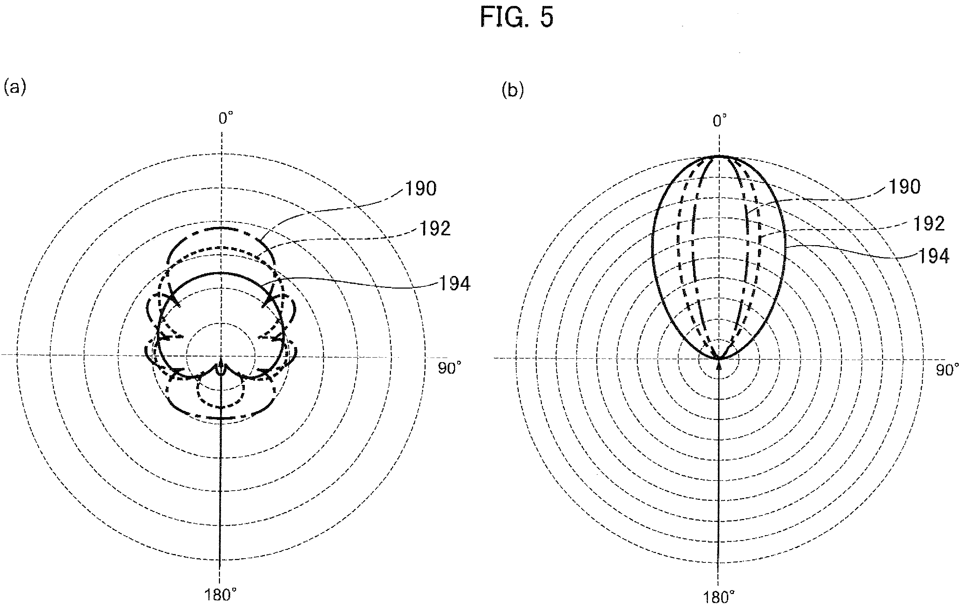

FIGS. 5A and 5B show scattering intensity distributions of the scattering material when the scattering intensity distributions were simulated by setting the particle size of the scattering material 27 to 500 nm, and show scattering intensity distributions of the scattering material when the straight direction component of the scattering intensity was normalized to 1. FIG. 5A shows scattering intensity distributions of the scattering material when the normalization was not performed, and FIG. 5B shows the scattering intensity distribution of the scattering material when the normalization was performed. It is understood that the scattering intensity is larger in FIG. 5A than in FIG. 4A, and that the difference of the directivity due to the wavelength is smaller in FIG. 5B than in FIG. 4B.

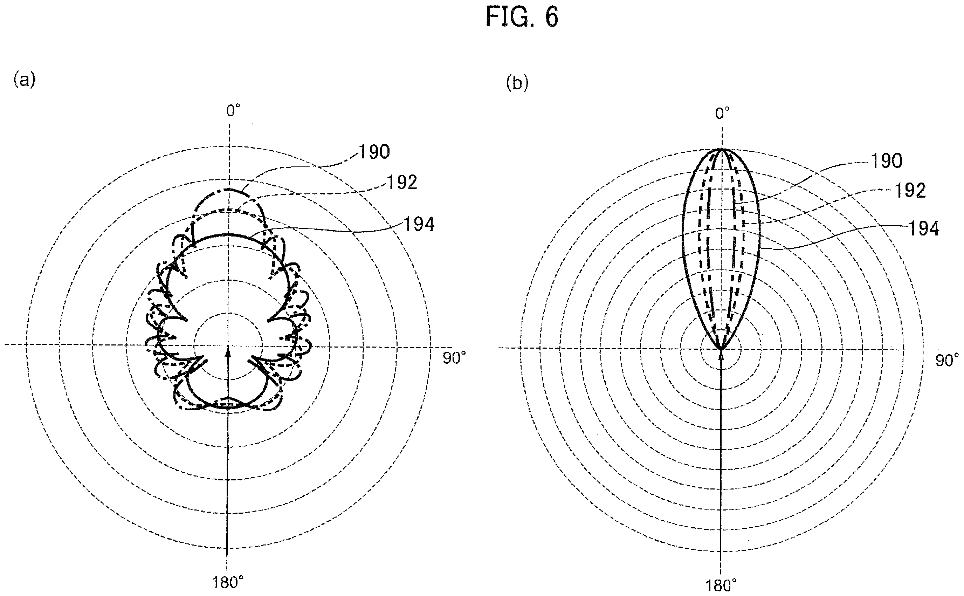

FIGS. 6A and 6B show scattering intensity distributions of the scattering material when the scattering intensity distributions were simulated by setting the particle size of the scattering material 27 to 1000 nm, and show scattering intensity distributions of the scattering material when the straight direction component of the scattering intensity was normalized to 1. FIG. 6A shows scattering intensity distributions of the scattering material when the normalization was not performed, and FIG. 6B shows the scattering intensity distribution of the scattering material when the normalization was performed. From FIG. 6A, it is understood that, in FIGS. 3 to 6, the scattering intensity is maximized when the particle size of the scattering material 27 is 1000 nm. From FIG. 6B, it is understood that, in FIGS. 3 to 6, the difference of the directivity due to wavelength is minimized when the particle size of the scattering material 27 is 1000 nm.

From FIG. 3 to FIG. 6, it is understood that, when the particle size of the scattering material 27 is decreased, backscattering becomes likely to occur, and the backscattering also tends to occur particularly for the light having a long wavelength. Moreover, it is understood that, as the particle diameter of the scattering material 27 becomes smaller, the wavelength dependence becomes larger, and the scattering intensity becomes smaller. Furthermore, it is understood that, as the particle diameter of the scattering material 27 becomes larger, the wavelength dependence becomes smaller, and the scattering intensity becomes larger. Therefore, it is preferable that the particle size of the scattering material 27 be determined so that the wavelength dependence can be large, and that the scattering intensity can be large. Based on the above-described simulation results of FIGS. 3 to 6, the scattering material having a particle size of 500 nm or less is preferable since the wavelength dependence thereof is large.

FIG. 7 is a graph showing wavelength dependences of transmittances of scattering members in which the scattering material 27 is dispersed. As each of the scattering members, such a scattering member was used, in which 5 mass parts of SiO₂ as the scattering material 27 is contained in 100 mass parts of EVA as the sealing material 21. That is, the scattering member does not contain the phosphor. Moreover, FIG. 7 shows results of values actually measured by using the scattering members actually fabricated.

In FIG. 7, an axis of abscissas represents the wavelength, and an axis of ordinates represents the transmittance. Moreover, in FIG. 7, reference numeral 150 denotes a graph of the scattering material having an average particle size of 100 nm, reference numeral 152 denotes a graph of the scattering material having an average particle size of 300 nm, and reference numeral 154 denotes a graph of the scattering material having an average particle size of 1000 nm. As shown in FIG. 7, it is understood that, in the graph 154 of the scattering material having the average particle size of 1000 nm, the change in the transmittance is small in all the measured wavelength regions including the excitation wavelength region 144 and light emission wavelength region 146 of the phosphor 25. Meanwhile, it is understood that, in the graph 150 of the scattering material having the average particle size of 100 nm and the graph 152 of the scattering material having the average particle size of 300 nm, the transmittance in the excitation wavelength region 144 is lower than the transmittance in the light emission wavelength region 146.

From these facts, it is understood that, as the particle size of the scattering material 27 is smaller, a degree of scattering only the light of the short wavelength strongly becomes larger, that is, the wavelength dependence becomes larger. Moreover, from the graphs 150 and 152, it is understood that, with regard to the scattering material having the average particle size of 100 nm and the scattering material having the average particle size of 300 nm, the absolute value of the light transmittance of the scattering material 27 is low in the excitation wavelength region 144 of the phosphor 25. Furthermore, it is understood that, with regard to the scattering material having the average particle size of 100 nm and the scattering material having the average particle size of 300 nm, the absolute value of the light transmittance of the scattering material 27 is high in the light emission wavelength region 146 of the phosphor 25. Therefore, it is understood that the scattering material having the average particle size of 100 nm and the scattering material having the average particle size of 300 nm have the first wavelength characteristics and the second wavelength characteristics, and have large wavelength dependence.

Meanwhile, from the graph 154, it is understood that, with regard to the scattering material having the average particle size of 1000 nm, the absolute value of the light transmittance of the scattering material 27 is high in the excitation wavelength region 144 of the phosphor 25, and the absolute value of the light transmittance of the scattering material 27 is relatively low in the light emission wavelength region 146 of the phosphor 25. Therefore, it is understood that the scattering material having the average particle size of 1000 mm does not have the first wavelength characteristics and the second wavelength characteristics.

Note that, although not shown in FIG. 7, it is confirmed that the scattering material having the average particle size of 500 nm has the first wavelength characteristics and the second wavelength characteristics, in which the wavelength dependence is increased. Therefore, it is known that all the scattering materials having the average particle sizes of 100 nm, 300 nm and 500 nm have large wavelength dependence. Therefore, when the average particle diameter of the scattering material 27 is usually 500 nm or less, preferably 400 nm or less, more preferably 300 nm or less, then this is preferable since the scattering materials have large wavelength dependence.

Note that, when a combination of the scattering material 27 and the sealing material 21 is made as follows, then this is preferable since the scattering material 27 scatters the light of the excitation wavelength of the phosphor 25 more than the light of the light emission wavelength of the phosphor 25. That is, it is preferable that the combination of the scattering material and the sealing material be set so that the refractive indices of the scattering material and the sealing material be the same or nearly the same in the wavelength region equal to or higher than the light emission wavelength of the phosphor, and that the refractive indices of the scattering material and the sealing material be different from each other in the wavelength region around the excitation wavelength of the phosphor.

### <Function of wavelength conversion member>

A function of the wavelength conversion member 20A will be described with reference to FIG. 2. The function of the wavelength conversion member 20A is the same as that of the wavelength conversion member 20 of the solar cell module 1 shown as the first embodiment in FIG. 1 except that the operation accompanying the scattering material 27 is added thereto. Therefore, with regard to the same function between the wavelength conversion member 20A and the wavelength conversion member 20, a description thereof is omitted or simplified.

When the solar cell module 1A is irradiated with sunlight including the ultraviolet light 70, the visible light and the infrared light 80, the ultraviolet light 70, the visible light and the infrared light 80 pass through the surface protection layer 30, and is made incident onto the wavelength conversion member 20A. The visible light and the infrared light 80, which are made incident onto the wavelength conversion member 20A, pass as they are through the wavelength conversion member 20A without being converted substantially by the phosphor 25, and then are applied to the solar cell 10. Meanwhile, among the ultraviolet light 70 made incident onto the wavelength conversion member 20A, the ultraviolet light 70 applied to the phosphor 25 is converted into the visible light and the infrared light 80, which are light on the long wavelength side, by the phosphor 25, and thereafter, are applied to the solar cell 10.

Moreover, among the ultraviolet light 70 made incident on the wavelength conversion member 20A, the ultraviolet light 70 applied to the scattering material 27 is scattered by the scattering material 27 since the light concerned is the light with the excitation wavelength of the phosphor 25. The ultraviolet light 70 scattered by the scattering material 27 and applied to the phosphor 25 is converted into the visible light and the infrared light 80, which are the light on the long wavelength side, by the phosphor 25, and thereafter, are applied to the solar cell 10. Note that the scattering material 27 is also irradiated with the visible light and the infrared light 80, which are radiated from the phosphor 25, as well as the ultraviolet light 70 made incident onto the wavelength conversion member 20A. However, since the visible light and the infrared light 80, which are applied to the scattering material 27, are the light with the light emission wavelength of the phosphor 25, the visible light and the infrared light 80 pass through the scattering material 27, and are applied to the solar cell 10. As described above, in the wavelength conversion member 20 A, the ultraviolet light 70, which passes through the sealing material 21 when the scattering material 27 is not present, is scattered by the scattering material 27 and is applied to the phosphor 25, and the phosphor 25 radiates the visible light and the infrared light 80. Moreover, since the visible light and the infrared light 80, which are radiated from the phosphor 25, are the light with the light emission wavelength of the phosphor 25, the visible light and the infrared light 80 pass through the scattering material 27 even if being applied thereto, and then are applied to the solar cell 10. As described above, since the wavelength conversion member 20A includes the scattering material 27, the ultraviolet light 70 made incident thereonto is applied to the phosphor 25 in a larger amount than in the wavelength conversion member 20 shown in FIG. 1, and a larger amount of the visible light and a larger amount of the infrared light 80 are obtained. Therefore, the wavelength conversion member 20A has higher light conversion efficiency than the wavelength conversion member 20 shown in FIG. 1. The solar cell 10 generates the photovoltaic power 90 by the applied visible light and infrared light 80, and the photovoltaic power 90 is supplied to the outside of the solar cell module 1 A via the terminals which are not shown.

### <Effect of wavelength conversion member>

The wavelength conversion member 20A for use in this embodiment has a similar effect to that of the wavelength conversion member 20 shown in FIG. 1. In addition, the wavelength conversion member 20A includes the scattering material 27, and accordingly, the wavelength conversion member 20A has higher light conversion efficiency than the wavelength conversion member 20 shown in FIG. 1.

### (Function of solar cell module)

The function of the solar cell module 1A has been described in the section on the function of the wavelength conversion member 20A, a description thereof is omitted.

### (Effect of solar cell module as photovoltaic device)

The solar cell module 1A as the photovoltaic device according to this embodiment exerts a similar effect to that of the solar cell module 1 shown in FIG. 1. In addition, the wavelength conversion member 20A includes the scattering material 27, and accordingly, the solar cell module 1A has higher light conversion efficiency than the solar cell module 1 shown in FIG. 1.

### EXAMPLES

Hereinafter, this embodiment will be described more in detail by examples; however, this embodiment is not limited to these examples.

Fluoride phosphors were synthesized by using a preparation method that utilizes the solid phase reaction, and characteristics thereof were evaluated.

Note that, in the examples, compound powders shown below were used as raw materials.

Barium fluoride (BaF₂): purity 3N, made by Wako Pure Chemical Industries, Ltd.

Strontium fluoride (SrF₂): purity 2N5, made by Wako Pure Chemical Industries, Ltd.

Calcium fluoride (CaF₂): purity 3N, made by Kojundo Chemical Laboratory Co., Ltd.

Magnesium fluoride (MgF₂): purity 2N, made by Wako Pure Chemical Industries, Ltd.

Europium fluoride (EuF₃): purity 3N, made by Wako Pure Chemical Industries, Ltd.

Barium carbonate (BaCO₃): purity 3N, made by Wako Pure Chemical Industries, Ltd.

### [Examples 1 to 16]

First, the respective raw materials were weighed at ratios shown in Table 1. Next, each of the raw materials was thoroughly dry-blended by using the magnetic mortar and the magnetic pestle, and a baking raw material was obtained. Thereafter, the baking raw material was transferred to the alumina crucible, and was baked for 2 hours in the reducing atmosphere (in the mixed gas atmosphere of 96% nitrogen and 4% hydrogen) at a temperature of 850°C by using the tubular atmosphere furnace. When a baked product thus obtained was disintegrated by using an alumina mortar and an alumina pestle, each of phosphors was obtained (Examples 1 to 16). Note that, as shown in Table 1, the phosphor of Example 16 was prepared by substituting BaCO₃ for a part of BaF₂ of a barium-containing raw material of Example 15. As shown in Table 2, the phosphor obtained in Example 16 contained oxygen atoms O.

**[Table 1]**

| | Composition | BaF₂ (g) | SrF₂ (g) | CaF₂ (g) | MgF₂ (g) | EuF₃ (g) | BaCO₃ (g) |
|---|---|---|---|---|---|---|---|
| Example 1 | (Ba_{2.17}Ca_{0.8}Eu_{0.03})Mg₄F₁₄ | 1.902 | 0.000 | 0.312 | 1.246 | 0.031 | 0.000 |
| Example 2 | (Ba_{2.11}Ca_{0.8}Eu_{0.09})Mg₄F₁₄ | 1.850 | 0.000 | 0.312 | 1.246 | 0.094 | 0.000 |
| Example 3 | (Ba_{2.05}Ca_{0.8}Eu_{0.15})Mg₄F₁₄ | 1.797 | 0.000 | 0.312 | 1.246 | 0.157 | 0.000 |
| Example 4 | (Ba_{1.99}Ca_{0.8}Eu_{0.21})Mg₄F₁₄ | 1.745 | 0.000 | 0.312 | 1.246 | 0.219 | 0.000 |
| Example 5 | (Ba_{1.9}Ca_{0.8}Eu_{0.3})Mg₄F₁₄ | 1.666 | 0.000 | 0.312 | 1.246 | 0.313 | 0.000 |
| Example 6 | Ba_{2.21}Ca_{0.7}Eu_{0.09}Mg₄F₁₄ | 1.937 | 0.000 | 0.273 | 1.246 | 0.094 | 0.000 |
| Example 7 | Ba_{2.01}Ca_{0.9}Eu_{0.09}Mg₄F₁₄ | 1.762 | 0.000 | 0.351 | 1.246 | 0.094 | 0.000 |
| Example 8 | Ba_{1.94}Ca_{0.97}Eu_{0.09}Mg₄F₁₄ | 1.701 | 0.000 | 0.379 | 1.246 | 0.094 | 0.000 |
| Example 9 | Ba_{1.91}CaEu_{0.09}Mg₄F₁₄ | 1.674 | 0.000 | 0.390 | 1.246 | 0.094 | 0.000 |
| Example 10 | Ba_{2.01}Sr_{0.1}Ca_{0.8}Eu_{0.09}Mg₄F₁₄ | 1.762 | 0.063 | 0.312 | 1.246 | 0.094 | 0.000 |
| Example 11 | Ba_{1.81}Sr_{0.3}Ca_{0.8}Eu_{0.09}Mg₄F₁₄ | 1.587 | 0.188 | 0.312 | 1.246 | 0.094 | 0.000 |
| Example 12 | Ba_{2.11}Ca_{0.7}Sr_{0.09}Mg₄F₁₄ | 1.850 | 0.063 | 0.273 | 1.246 | 0.094 | 0.000 |
| Example 13 | Ba_{2.11}Ca_{0.5}Eu_{0.09}Mg₄F₁₄ | 1.850 | 0.188 | 0.195 | 1.246 | 0.094 | 0.000 |
| Example 14 | Ba_{2.11}Ca_{0.3}Sr_{0.5}Eu_{0.09}Mg₄F₁₄ | 1.850 | 0.314 | 0.117 | 1.246 | 0.094 | 0.000 |
| Example 15 | Ba₂Ca_{0.91}Eu_{0.09}Mg₄F₁₄ | 1.753 | 0.000 | 0.355 | 1.246 | 0.094 | 0.000 |
| Example 16 | Ba₂Ca_{0.91}Eu_{0.09}Mg₄F₁₃O | 0.877 | 0.000 | 0.355 | 1.246 | 0.094 | 0.987 |
| Comparative example 1 | Ca_{0.997}Eu_{0.003}F₂ | 0.000 | 0.000 | 7.784 | 0.000 | 0.063 | 0.000 |

When each of the obtained phosphors was irradiated with ultraviolet rays (wavelength: 365 nm), blue fluorescence was visually observed in each of Examples 1 to 16.

For each of the obtained phosphors, a light emission peak wavelength and relative internal quantum efficiency were measured. Here, the light emission peak wavelength is a peak wavelength of the light emission spectrum when the phosphor is excited with light having a wavelength of 350 nm. Moreover, the relative internal quantum efficiency is efficiency that indicates, by %, a ratio of internal quantum efficiency IQE₈₀ of the phosphor at 80°C to internal quantum efficiency IQE₃₀ of the phosphor at 30°C when the phosphor is excited by the light having the wavelength of 350 nm. Specifically, the relative internal quantum efficiency is a numeric value obtained by (IQE₈₀/IQE₃₀)×100. Table 2 shows measurement results of the light emission peak wavelength and the relative internal quantum efficiency.

**[Table 2]**

| | Composition | Light Emission Peak Wavelength (nm) | Relative Internal Quantum Efficiency (%) | Refractive Index |
|---|---|---|---|---|
| Example 1 | (Bn_{2.17}Ca_{0.8}Eu_{0.03})Mg₄F₁₄ | 448 | 97 | 1.45 |
| Example 2 | (Ba_{2.11}Ca_{0.8}Eu_{0.09})Mg₄F₁₄ | 458 | 98 | 1.45 |
| Example 3 | (Ba_{2.05}Ca_{0.8}Eu_{0.15})Mg₄F₁₄ | 460 | 98 | 1.45 |
| Example 4 | (Ba_{1.99}Ca_{0.8}Eu_{0.21})Mg₄F₁₄ | 460 | 98 | 1.45 |
| Example 5 | (Ba_{1.9}Ca_{0.8}Eu_{0.3})Mg₄F₁₄ | 457 | 98 | 1.45 |
| Example 6 | Ba_{2.21}Ca_{0.7}Eu_{0.09}Mg₄F₁₄ | 460 | 97 | 1.45 |
| Example 7 | Ba_{2.01}Ca_{0.9}Eu_{0.09}Mg₄F₁₄ | 456 | 98 | 1.45 |
| Example 8 | Ba_{1.94}Ca_{0.97}Eu_{0.09}Mg₄F₁₄ | 455 | 97 | 1.45 |
| Example 9 | Ba_{1.91}CaEu_{0.09}Mg₄F₁₄ | 456 | 97 | 1.45 |
| Example 10 | Ba_{2.01}Sr_{0.1}Ca_{0.8}Eu_{0.09}Mg₄F₁₄ | 450 | 97 | 1.45 |
| Example 11 | Ba_{1.81}Sr_{0.3}Ca_{0.8}Eu_{0.09}Mg₄F₁₄ | 441 | 97 | 1.45 |
| Example 12 | Ba_{2.21}Ca_{0.7}Sr_{0.1}Eu_{0.09}Mg₄F₁₄ | 455 | 96 | 1.45 |
| Example 13 | Ba_{2.11}Ca_{0.5}Sr_{0.3}Eu_{0.09}Mg₄F₁₄ | 450 | 98 | 1.45 |
| Example 14 | Ba_{2.11}Ca_{0.3}Sr_{0.5}Eu_{0.09}Mg₄F₁₄ | 444 | 99 | 1.45 |
| Example 15 | Ba₂Ca_{0.91}Eu_{0.09}Mg₄F₁₄ | 455 | 98 | 1.45 |
| Example 16 | Ba₂Ca_{0.91}Eu_{0.09}Mg₄F₁₃O | 455 | 98 | 1.46 |
| Comparative example 1 | Ca_{0.997}Eu_{0.003}F₂ | 427 | 80 | 1.44 |

Refractive indices were measured for the obtained phosphors. The refractive indices were measured by the Becke line method (according to JIS K 7142 B method) by using the Abbe refractometer NAR-2T manufactured by Atago Co., Ltd. and the polarization microscope BH-2 manufactured by Olympus Corporation. Measurement conditions were set as follows.
Immersion liquid: propylene carbonate (n_{D}23 1.420)
   butyl phthalate (n_{D}23 1.491)
Temperature: 23 °C
Light source: Na (D line/589 nm)

Table 2 shows measurement results of the refractive index. As shown in Table 2, the refractive index of the phosphor (Ba₂Ca_{0.91}Eu_{0.09}Mg₄F₁₄) of Example 15 was 1.45, whereas the refractive index of the phosphor (Ba₂Ca_{0.91}Eu_{0.09}Mg₄F₁₃O) of Example 16 was 1.46. It is understood that, as described above, the phosphor of Example 16, which has a composition that contains oxygen, exhibits a higher refractive index than the phosphor of Example 15, which has a composition that does not contain oxygen.

Moreover, excitation characteristics and light emission characteristics of the compound of Example 2 were measured. The excitation characteristics and the light emission characteristics were evaluated by measuring an excitation spectrum and a light emission spectrum by using the spectrofluorophotometer (FP-6500 (product name: manufactured by JASCO Corporation)). An excitation wavelength at the time of measuring the light emission spectrum was set to 350 nm, and a monitoring wavelength at the time of measuring the excitation spectrum was set to a light emission peak wavelength (458 nm).

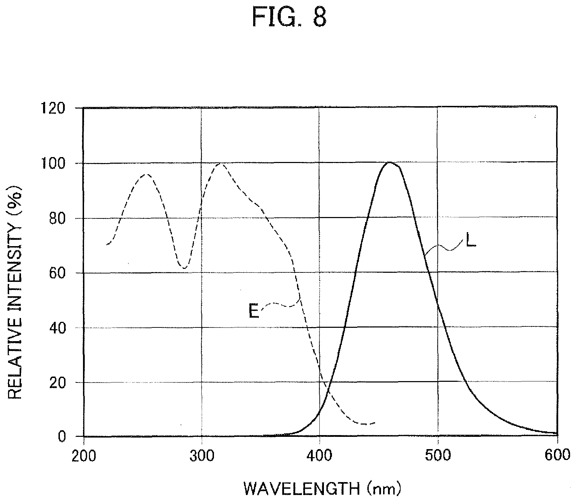

FIG. 8 shows measurement results. In FIG. 8, reference symbol E denotes the excitation spectrum and reference symbol L denotes the light emission spectrum. As shown in FIG. 8, it is understood that the compound of Example 2 absorbs the ultraviolet light having a wavelength of 300 nm or more to less than 400 nm, and exhibits light emission having a peak at 458 nm.

### [Comparative example 1]

Comparative example 1 was synthesized by using the solid phase reaction in a similar way to the compounds of the examples. First, the respective raw materials were weighed at ratios shown in Table 1. Next, the raw materials were thoroughly dry-blended by using the magnetic mortar and the magnetic pestle, and a baking raw material was obtained. Thereafter, the baking raw material was transferred to the alumina crucible, and was baked for 2 hours in the reducing atmosphere (in the mixed gas atmosphere of 96% nitrogen and 4% hydrogen) at a temperature of 1200°C by using the tubular atmosphere furnace. When a baked product thus obtained was disintegrated by using the alumina mortar and the alumina pestle, a phosphor was obtained.

When the obtained phosphor was irradiated with the ultraviolet rays (wavelength: 365 nm), bluish purple fluorescence was visually observed.

For the obtained phosphor, a light emission peak wavelength, relative internal quantum efficiency and a refractive index were measured in a similar way to Example 1. Table 2 shows measurement results of these.

From the results of Examples 1 to 16 and Comparative example 1, it is understood that each of the compounds of Examples 1 to 16 emits light in the visible light region with the wavelength of 400 nm or more. Moreover, the relative internal quantum efficiency of each of Examples 1 to 16 was 95% or more, and it is understood that the temperature quenching characteristics of Examples 1 to 16 are better than that of Comparative example 1 in which the relative internal quantum efficiency is 80%. Moreover, it is understood that, in each of Example 2 and Comparative example 1, the refractive index stays within the range of 1.41 or more to less than 1.57, and has a value close to a refractive index of a general sealing material.

### [Example 17]

A wavelength conversion member was produced by using the phosphor of Example 2 and the sealing material. First, the phosphor of Example 2 and EVA (Evaflex EV450) made by Mitsui-Dupont Polychemicals Co., Ltd. were weighed so as to obtain blending amounts shown in Table 3. Next, by using a plastomill manufactured by Toyo Seiki Co., Ltd., the phosphor and EVA as the sealing material were melt-kneaded at a temperature of 150°C and a number of revolutions of 30 rpm for 30 minutes, whereby a mixture of the fluoride phosphor of Example 2 and an ethylene-vinyl acetate copolymer was obtained. Moreover, the obtained mixture was subjected to hot press by using a hot press machine at a heating temperature of 150°C and a pressing pressure of 1.5 MPa, and then a sheet-shaped wavelength conversion member having a thickness of 0.6 mm was obtained.

Transmittance of the obtained wavelength conversion member was measured. The transmittance was measured by using the ultraviolet-visible-near-infrared spectrophotometer UV-2600 manufactured by Shimadzu Corporation. Measurement conditions were set as follows.
Measurement range: 300 to 800 nm
Scan speed: 600 nm/min
Sampling interval: 1 nm
Slit width: 2 nm
Light source switching wavelength: 340 nm
Light source (300 - 340 nm): deuterium lamp
Light source (340 to 800 nm): tungsten halogen lamp

Table 3 shows measurement results of the transmittance for light having a wavelength of 590 nm.

**[Table 3]**

| | Phosphor | | Sealing Material | | Transmittance (%) |
|---|---|---|---|---|---|
| | Type | Blending Amount (g) | Type | Blending Amount (g) | |
| Example 17 | Example 2 | 11 | EVA | 46 | 81 |
| Comparative example 2 | BAM | 11 | EVA | 46 | 42 |

### [Comparative example 2]

A wavelength conversion member was obtained in a similar way to Example 17 except that BaMgAl₁₀O₁₇: Eu²⁺ (BAM phosphor, refractive index: 1.77) was used instead of the phosphor of Example 2. Transmittance of the obtained wavelength conversion member was measured in a similar way to Example 17. Table 3 shows measurement results of the transmittance.

From the results of Example 17 and Comparative example 2, it is understood that the transmittance of the wavelength conversion member of Example 17 is as high as 81%. Meanwhile, it is understood that the transmittance of the wavelength conversion member of Comparative example 2 is as low as 42%. This is presumed to be because the refractive index of the compound of Example 2 is 1.45, which is close to the refractive index (1.48) of the EVA, whereas the refractive index of the BAM phosphor of Comparative example 2 is 1.77, which is greatly different from the refractive index of the EVA. Specifically, it is considered that, since the BAM phosphor of Comparative example 2 has a large refractive index difference from the EVA as the sealing material, the light that hit phosphor particles is scattered, resulting in the decrease of the transmittance. Meanwhile, it is considered that, since the phosphor of Example 2 has a small refractive index difference from the EVA as the sealing material, the scattering of the light is suppressed, resulting in that high transmittance is exhibited.

The entire content of Japanese Patent Application No. P2015-022868 (filed on: February 9, 2015) and Japanese Patent Application No. P2015-211665 (filed on: December 28, 2015) are herein incorporated by reference.

Although the present invention has been described above by reference to the embodiments and the example, the present invention is not limited to those, and it will be apparent to these skilled in the art that various modifications and improvements can be made.

### INDUSTRIAL APPLICABILITY

The phosphor of the present invention is capable of converting the ultraviolet light into the visible light or the infrared light at room temperature or more, has the small refractive index difference from the sealing material of the wavelength conversion member, has the light emission characteristics unchanged even if coming into contact with moisture, and has high reliability.

The wavelength conversion member of the present invention is capable of converting the ultraviolet light into the visible light or the infrared light at room temperature or more, has the small refractive index difference between the refractive index of the phosphor and the refractive index of the sealing material, has the light emission characteristics unchanged even if coming into contact with moisture, and has high reliability.

The photovoltaic device of the present invention is capable of converting the ultraviolet light into the visible light or the infrared light at room temperature or more, has the small refractive index difference between the refractive index of the phosphor and the refractive index of the sealing material in the wavelength conversion member, has the light emission characteristics unchanged even if coming into contact with moisture, and has high reliability. Moreover, the transmittance of the wavelength conversion member for the above-described visible light and infrared light of the photovoltaic device of the present invention is high, and accordingly, the photovoltaic device of the present invention has high photoelectric conversion efficiency.

### REFERENCE SIGNS LIST

- 1, 1A: solar cell module (photovoltaic device)
- 20, 20A: wavelength conversion member
- 21: sealing material
- 25: phosphor
- 27: scattering material

## Claims

1. A phosphor,
wherein the phosphor has a crystal structure in which at least one of Ce³⁺ and Eu²⁺ is substituted for a part of a host crystal that contains at least one of an alkaline earth metal element and a rare earth element and does not contain an alkaline metal element,
a light emission spectrum measured at room temperature has a light emission peak within a wavelength range of 440 nm or more to less than 1200 nm, the light emission peak being derived from at least one of Ce³⁺ and Eu²⁺,
the light emission peak indicates a maximum intensity value of the light emission spectrum, and
a refractive index is 1.41 or more to less than 1.57.

2. The phosphor according to claim 1, wherein an excitation spectrum of the phosphor has light absorption within a wavelength range of 300 nm or more to less than 400 nm, the light absorption being brought by at least one of Ce³⁺ and Eu²⁺.

3. The phosphor according to claim 2, wherein the excitation spectrum is a spectrum that is based on electron energy transition of Eu²⁺.

4. The phosphor according to any one of claims 1 to 3, wherein the phosphor contains an alkaline earth metal element.

5. The phosphor according to claim 4, wherein the phosphor is a fluoride containing the alkaline earth metal element and magnesium.

6. The phosphor according to claim 5, wherein the fluoride has a crystal structure in which at least one of Ce³⁺ and Eu²⁺ is substituted for a part of atoms constituting a host crystal having a composition represented by formula (1) described below:
M₃Mg₄F₁₄ (1)
(where M is at least one alkaline earth metal element selected from the group consisting of Ca, Sr and Ba.).

7. The phosphor according to claim 6, wherein the host crystal of the fluoride has a composition in which O is substituted for a part of F in formula (1).

8. The phosphor according to any one of claims 1 to 7, wherein the phosphor further contains Mn²⁺.

9. The phosphor according to any one of claims 1 to 8, wherein a 10% diameter D₁₀ of the fluoride is 15 µm or more, and a median diameter of the fluoride is less than 1000 µm.

10. A wavelength conversion member comprising the phosphor according to any one of claims 1 to 9.

11. The wavelength conversion member according to claim 10 further comprising a scattering material that scatters light with an excitation wavelength more than light with a light emission wavelength of the phosphor.

12. The wavelength conversion member according to either one of claims 10 and 11, wherein the scattering material scatters light having a wavelength of 400 nm or less.

13. The wavelength conversion member according to any one of claims 10 to 12, wherein the scattering material is granular, in which a 50% diameter D₅₀ is less than 400 nm.

14. A photovoltaic device comprising the phosphor according to any one of claims 1 to 9.

15. A photovoltaic device comprising the wavelength conversion member according to any one of claims 10 to 13.
